# EUROPÄISCHE PATENTANMELDUNG

(11) **EP 1 970 953 A1**
(43) Veröffentlichungstag der Anmeldung: **17.09.2008**
(21) Anmeldenummer: 08102388.9
(22) Anmeldetag: 07.03.2008
(51) Int. Cl.: H01L 23/29

(54) **Vergossene Elektroanordnung und Verfahren zum Vergießen einer wenigstens ein Elektrobauteil aufweisenden Elektroanordnung**

(30) Priorität: 10.03.2007 DE 102007012003
(71) Anmelder: Bergmann, Klaus-Peter, 58332 Schwelm (DE); Schlechtendahl, Ralf, 42719 Solingen (DE)
(72) Erfinder: Bergmann, Klaus-Peter, 58332 Schwelm (DE); Schlechtendahl, Ralf, 42719 Solingen (DE)
(74) Vertreter: Michalski Hüttermann & Partner Patentanwälte

(57) **Zusammenfassung**

Die Erfindung betrifft eine vergossene Elektroanordnung, mit wenigstens einem mit einem Vergußmaterial vergossenen Elektrobauteil sowie ein Verfahren zum Vergießen einer wenigstens ein Elektrobauteil aufweisenden Elektroanordnung. Erfindungsgemäß ist vorgesehen, daß das Vergußmaterial vernetztes Polymethylmethacrylat aufweist. Auf diese Wcisc ist eine Vcrarbcitung des Vcrgußmatcrials bei Raumtemperatur möglich, wobei ein hochtemperaturfester Verguß mit hoher mechanischer Festigkeit erzielt wird.

## Beschreibung

Die Erfindung betrifft eine vergossene Elektroanordnung mit wenigstens einem mit einem Vergußmaterial vergossenen Elektrobauteil sowie ein Verfahren zum Vergießen einer wenigstens ein Elektrobauteil aufweisenden Elektroanordnung.

Mit dem Begriff "Elektroanordnung" ist vorliegend eine elektrische oder elektronische Anordnung gemeint, wobei der Begriff "Elektrobauteil" ein elektrisches oder elektronisches Bauteil sein soll. Das Vergießen von elektrischen und elektronischen Bauteilen bei Elektroanordnungen ist aus der Praxis gut bekannt. Ein derartiges Vergießen erfolgt z. B. aus Gründen des Explosionsschutzes, zur elektrischen Isolierung oder auch zum rein mechanischen Schutz. Die Anwendungsgebiete sind vielfältig, und entsprechend unterschiedlich sind die verwendeten Vergußmaterialien.

Mitunter kann das Vergußmaterial nicht bei Raumtemperatur verarbeitet werden, sondern muß zum Vergießen erhitzt werden. Dies kann dazu führen, daß aufgrund der hohen Temperaturen beim Vergießen temperaturempfindliche Elektrobauteile Schaden nehmen. Darüber hinaus zeigen viele Vergußmaterialien nur eine moderate Wärmebeständigkeit; Temperaturen über 200 °C sind in der Regel äußerst problematisch.

Vor dem zuvor geschilderten Hintergrund stellt sich die Aufgabe der Erfindung, eine derartige vergossene Elektroanordnung sowie ein derartiges Verfahren zum Vergießen einer Elektroanordnung anzugeben, wobei das Vergießen in einem für ein Elektrobauteil unproblematischen Temperaturbereich erfolgen kann und dabei für die vergossene Elektroanordnung eine sehr hohe Temperaturbeständigkeit erzielt wird.

Ausgehend von der eingangs beschriebenen Elektroanordnung ist diese Aufgabe dadurch gelöst, daß das Vergußmaterial vernetztes Polymethylmethacrylat (PMMA) aufweist.

Der Erfindung liegt damit die Erkenntnis zugrunde, daß sich ein vernetztes Polymethylmethacrylat aus einer bei Raumtemperatur verarbeitbaren Mischung herstellen läßt, wobei sich überraschenderweise eine Temperaturbeständigkeit von über 200 °C ergibt.

Dabei kann das Vergußmaterial neben dem vernetzten Polymethylmethacrylat weitere Bestandteile aufweisen. Gemäß einer bevorzugten Weiterbildung der Erfindung ist jedoch vorgesehen, daß das Vergußmaterial aus vernetztem Polymethylmethacrylat besteht.

Grundsätzlich sind für das erfindungsgemäße vernetzte Polymethylmethacrylat als Vergußmaterial für die Elektroanordnung verschiedene Herstellungsverfahren möglich. Gemäß einer bevorzugten Weiterbildung der Erfindung ist jedoch vorgesehen, daß das Vergußmaterial erhältlich ist ausgehend von einer Mischung die aufweist: Polymethylmethacrylat, Ethylenmethacrylat, Methacrylat und einen Polymerisationsinitiator. Ganz besonders bevorzugt ist als Polymerisationsinitiator ein Peroxid vorgesehen, vorzugsweise ein organisches Peroxid. Ein besonders geeignetes Peroxid ist z. B. Dibenzoylperoxid. Als Polymerisationsinitiator kommen gemäß einer bevorzugten Weiterbildung der Erfindung auch andere Radikalstarter in Frage, wie Azobisisobutyronitril (AIBN).

Wie zuvor schon ausgeführt, kann das Vergußmaterial neben vernetztem Polymethylmethacrylat weitere Bestandteile aufweisen. Gemäß einer bevorzugten Weiterbildung der Erfindung ist jedoch vorgesehen, daß das Vergußmaterial erhältlich ist ausgehend von einer Mischung, die aus Polymethylmethacrylat, Ethylenmethacrylat, Methacrylat und einem Polymerisationsinitiator, wie einem Peroxid, besteht.

Das Polymethylmethacrylat kann in verschiedenen Formen vorliegen. Gemäß einer bevorzugten Weiterbildung der Erfindung ist jedoch vorgesehen, daß die Mischung, aus der das Vergußmaterial erhältlich ist, Polymethylmethacrylat in Perlenform aufweist.

Es hat sich gezeigt, daß ein gut verarbeitbares Vergußmaterial, das hohen Temperaturen widerstehen kann, insbesondere dann erhältlich ist, wenn die Mischung aufweist: 60 - 80 Gew.-% Polymethylmethacrylat, 14 - 22 Gew.-% Ethylenmethacrylat, 7-13 Gew.-% Methacrylat und 1-4 Gew.-% eines Peroxids.

Ganz besonders bevorzugt ist eine Mischung, die aus 70 Gew.-% Polymethylmethacrylat, 18 Gew.-% Ethylenmethacrylat, 10 Gew.-% Methacrylat und 2 Gew.-% eines Peroxids, wie Dibenzoylperoxid, besteht. Eine derartige Mischung kann bei Raumtemperatur auf einfache Weise, nämlich durch Gießen, verarbeitet werden, wobei die schon angesprochene hohe Temperaturfestigkeit erzielt wird.

Grundsätzlich kann das Vergußmaterial in einer verlorenen Form vergossenen werden. Gemäß einer bevorzugten Weiterbildung der Erfindung ist das Vergußmaterial jedoch in einem Gehäuse, vorzugsweise nämlich in einem Kunststoffgehäuse vorgesehen. Dabei ist es ganz besonders bevorzugt, daß das Gehäuse aus Polyphenylenoxid (PPO) besteht.

Ausgehend von dem eingangs beschriebenen Verfahren zum Vergießen einer wenigstens ein Elektrobauteil aufweisenden Elektroanordnung ist die weiter oben genannte Aufgabe dadurch gelöst, daß zum Vergießen eine Mischung von Polymethylmethacrylat mit einem Vernetzungszusatz verwendet wird.

Wie zuvor schon ausgeführt, ist als Vernetzungszusatz insbesondere vorgesehen eine Mischung von Ethylenmethacrylat, Methacrylat und einem Polymerisationsinitiator, wie einem Peroxid.

Bevorzugte Weiterbildungen des erfindungsgemäßen Verfahrens ergeben sich in Analogie zu den bevorzugten Weiterbildungen der erfindungsgemäßen vergossenen Elektroanordnung.

Insbesondere ist gemäß einer bevorzugten Weiterbildung der Erfindung vorgesehen, daß das Vergußmaterial hergestellt wird ausgehend von einer Mischung, die aus Polymethylmethacrylat, Ethylenmethacrylat, Methacrylat und einem Polymerisationsinitiator besteht.

Vorzugsweise ist außerdem vorgesehen, daß als Polymerisationsinitiator ein Peroxid vorgesehen wird. Vorzugsweise ist weiterhin vorgesehen, daß die Mischung Polymethylmethacrylat-Perlen aufweist.

Gemäß einer bevorzugten Weiterbildung der Erfindung ist vorgesehen, daß die Mischung 60 - 80 Gew.-% Polymethylmethacrylat aufweist, daß die Mischung 14 - 22 Gew.-% Ethylenmethacrylat aufweist, daß die Mischung 7-13 Gew.-% Methacrylat aufweist, und/oder daß die Mischung 1 - 4 Gew.-% eines Peroxids, wie Dibenzoylperoxid, aufweist. Ganz besonder ist bevorzugt, daß die Mischung 70 Gew.-% Polymethylmethacrylat, 18 Gew.-% Ethylenmethacrylat, 10 Gew.-% Methacrylat und 2 Gew.-% eines Peroxids aufweist.

Vorzugsweise ist ferner vorgesehen, daß der Verguß in einem Gehäuse, vorzugsweise in einem Kunststoffgehäuse, durchgeführt wird. Ganz besonders bevorzugt wird das Vergießen bei Raumtemperatur durchgeführt. Dabei ist weiterhin bevorzugt, dass die Elektroanordnung nach dem Vergießen für eine vorbestimmte Zeitdauer auf eine Temperatur oberhalb Raumtemperatur gebracht wird. Insbesondere ist diesbezüglich bevorzugt, daß nach einem Aushärten bei Raumtemperatur von 1-2 Stunden eine Erhitzung auf 70 - 90 °C, vorzugsweise auf 80 °C, durchgeführt wird, insbesondere daß die Erhitzung für 3 - 4 Minuten durchgeführt wird. Vorzugsweis wird die Erhitzung in einem Ofen durchgeführt.

Nachfolgend wird die Erfindung anhand eines Ausführungsbeispiels im Detail erläutert.

Zur Herstellung einer vergossenen Elektroanordnung gemäß einem bevorzugten Ausführungsbeispiel der Erfindung wird zuerst ein Kunststoffgehäuse aus PPO bereitgestellt. In diesem Kunststoffgehäuse werden alle Elektrobauteile montiert und eingebaut. Werden als elektrische Bauteile z. B. Anschlußklemmen verwendet, so werden diese derart angeordnet, daß sie nach dem Verguß zum Anschluß weiterer Elektrobauteile von außen zugänglich sind.

Nachfolgend wird eine Mischung erstellt, die aus 70 Gew.-% PMMA-Perlen, 18 Gew.-% Ethylenmethacrylat, 10 Gew.-% Methacrylat und 2 Gew.-% des Peroxids Dibenzoylperoxid besteht. Nach Anrühren dieser Mischung wird diese bei Raumtemperatur von ca. 20 °C in das Gehäuse gegossen. Wie zuvor schon angesprochen, wird beim Gießen darauf geachtet, daß Elektrobauteile, wie Klemmen von außerhalb des Vergusses zugänglich bleiben.

Nach einer ersten Aushärtezeit von ein bis zwei Stunden wird das Gehäuse mit der vergossenen Elektroanordnung in einem Ofen für ca. drei bis vier Minuten auf 80 °C erhitzt.

Nach der Abkühlung der vergossenen Elektroanordnung erhält man dann einen Verguß, der mechanisch fest ist und Temperaturen von über 200 °C widerstehen kann. Auf diese Weise können Elektrobauteile einer Elektroanordnung feuchtigkeitsdicht in einem Elektrogehäuse vorgesehen werden, so daß z. B. auch Schwitzwasser in dem Gehäuse unproblematisch ist.

## Patentansprüche

1. Vergossene Elektroanordnung, mit wenigstens einem mit einem Vergußmaterial vergossenen Elektrobauteil, **dadurch gekennzeichnet, daß** das Vergußmaterial vernetztes Polymethylmethacrylat aufweist.

2. Vergossene Elektroanordnung nach Anspruch 1, **dadurch gekennzeichnet, daß** das Vergußmaterial erhältlich ist ausgehend von einer Mischung, die aufweist: Polymethylmethacrylat, Ethylenmethacrylat, Methacrylat und einen Polymerisationsinitiator.

3. Vergossene Elektroanordnung nach Anspruch 1 oder 2, **dadurch gekennzeichnet, daß** das Vergußmaterial erhältlich ist ausgehend von einer Mischung, die aus Polymethylmethacrylat, Ethylenmethacrylat, Methacrylat und einem Polymerisationsinitiator, wie einem Peroxid, besteht.

4. Vergossene Elektroanordnung nach einem der Ansprüche 1 bis 3, **dadurch gekennzeichnet, daß** das Vergußmaterial in einem Gehäuse, vorzugsweise in einem Kunststoffgehäuse, vorgesehen ist.

5. Verfahren zum Vergießen einer wenigstens ein Elektrobauteil aufweisenden Elektroanordnung, **dadurch gekennzeichnet, daß** zum Vergießen eine Mischung von Polymethylmethacrylat mit einem Vernetzungszusatz verwendet wird.

6. Verfahren nach Anspruch 5, **dadurch gekennzeichnet, daß** das Vergußmaterial hergestellt wird ausgehend von einer Mischung, die aufweist, Polymethylmethacrylat, Ethylenmethacrylat, Methacrylat und einen Polymerisationsinitiator.

7. Verfahren nach einem Anspruch 5 oder 6, **dadurch gekennzeichnet, daß** die Mischung Polymethylmethacrylat-Perlen aufweist.

8. Verfahren nach einem der Ansprüche 13 bis 17, **dadurch gekennzeichnet, daß** die Mischung 60 - 80 Gew.-% Polymethylmethacrylat, 14 - 22 Gew.-% Ethylenmethacrylat, 7 - 13 Gew.-% Methacrylat und/oder 1 - 4 Gew.-% eines Peroxids, wie Dibenzoylperoxid, aufweist.

9. Verfahren nach einem der Ansprüche 5 bis 8, **dadurch gekennzeichnet, daß** das Vergießen bei Raumtemperatur durchgeführt wird.

10. Verfahren nach Anspruch 9, **dadurch gekennzeichnet, daß** die Elektroanordnung nach dem Vergießen für eine vorbestimmte Zeitdauer auf eine Temperatur oberhalb Raumtemperatur gebracht wird.
